# FASCICULE DE BREVET EUROPEEN

(11) **EP 2 715 782 B1**
(45) Date de publication et mention de la délivrance du brevet: **19.12.2018**
(21) Numéro de dépôt: 12721321.3
(22) Date de dépôt: 18.05.2012
(51) Int. Cl.: H01L 21/027, B82Y 10/00, B81C 1/00

(54) **PROCÉDÉ DE RÉALISATION DE MOTIFS À LA SURFACE D'UN SUBSTRAT UTILISANT DES COPOLYMERES À BLOC**
VERFAHREN ZUR HERSTELLUNG VON MUSTERN AUF DER OBERFLÄCHE EINES SUBSTRATS UNTER VERWENDUNG VON BLOCK-COPOLYMEREN
METHOD FOR MAKING PATTERNS ON THE SURFACE OF A SUBSTRATE USING BLOCK COPOLYMERS

(30) Priorité: 27.05.2011 FR 1154675
(43) Date de publication de la demande: 09.04.2014
(73) Titulaire: Commissariat à l'Énergie Atomique et aux Énergies Alternatives, 75015 Paris (FR)
(72) Inventeur: TIRON, Raluca, 38950 Saint-Martin Le Vinoux (FR); GAUGIRAN, Stéphanie, 38100 Grenoble (FR); CHEVALIER, Xavier, 38100 Grenoble (FR); TEDESCO, Serge, 38700 Corenc (FR)
(74) Mandataire: Lebkiri, Alexandre
(86) Numéro de dépôt international: PCT/EP2012/059295
(87) Numéro de publication internationale: WO 2012/163702

(56) Documents cités:
- WO-A1-2009/094282
- US-A1- 2010 093 172
- SEONG-JUN JEONG ET AL: "Ultralarge-area block copolymer lithography via soft graphoepitaxy", JOURNAL OF MATERIALS CHEMISTRY, vol. 21, no. 16, 1 janvier 2011 (2011-01-01), page 5856, XP055007234, ISSN: 0959-9428, DOI: 10.1039/c0jm04248j
- KIM HO-CHEOL ET AL: "Surface patterns from block copolymer self-assembly", JOURNAL OF VACUUM SCIENCE AND TECHNOLOGY: PART A, AVS /AIP, MELVILLE, NY., US, vol. 26, no. 6, 30 octobre 2008 (2008-10-30), pages 1369-1382, XP012114029, ISSN: 0734-2101, DOI: 10.1116/1.3000056
- XIAO SHUAIGANG ET AL: "Graphoepitaxial cylindrical block copolymer nanodomains evaluated as bit patterned media template", JOURNAL OF VACUUM SCIENCE AND TECHNOLOGY: PART B, AVS / AIP, MELVILLE, NEW YORK, NY, US, vol. 25, no. 6, 6 décembre 2007 (2007-12-06), pages 1953-1957, XP012105397, ISSN: 1071-1023, DOI: 10.1116/1.2801860
- WELANDER ADAM ET AL: "Impact of trench width roughness on the graphoepitaxial assembly of block copolymers", JOURNAL OF VACUUM SCIENCE AND TECHNOLOGY: PART B, AVS / AIP, MELVILLE, NEW YORK, NY, US, vol. 26, no. 6, 1 décembre 2008 (2008-12-01), pages 2484-2488, XP012114498, ISSN: 1071-1023, DOI: 10.1116/1.2987963
- P. MANSKY: "Controlling Polymer-Surface Interactions with Random Copolymer Brushes", SCIENCE, vol. 275, no. 5305, 7 mars 1997 (1997-03-07), pages 1458-1460, XP55017500, ISSN: 0036-8075, DOI: 10.1126/science.275.5305.1458
- JOY Y. CHENG ET AL: "Simple and Versatile Methods To Integrate Directed Self-Assembly with Optical Lithography Using a Polarity-Switched Photoresist", ACS NANO, vol. 4, no. 8, 24 août 2010 (2010-08-24), pages 4815-4823, XP055007223, ISSN: 1936-0851, DOI: 10.1021/nn100686v

## Description

### DOMAINE TECHNIQUE

La présente invention concerne un procédé de réalisation de motifs à la surface d'un substrat utilisant des copolymères à bloc afin de générer des motifs de très hautes résolution et densité. L'invention concerne plus particulièrement un procédé de graphoépitaxie utilisant des copolymères à bloc.

### ETAT DE LA TECHNIQUE ANTERIEUR

Les besoins de procédés pour réaliser des objets présentant des motifs nanométriques ont fortement augmenté ces dix dernières années, et ce en raison de la tendance à la miniaturisation des composants.

Initialement, les motifs étaient réalisés par lithographie optique. Dans ce procédé de réalisation, la résolution est proportionnelle à la longueur d'onde et inversement proportionnelle à l'ouverture numérique, de sorte que la résolution obtenue par ce procédé est limitée.

Afin d'obtenir de meilleures résolutions, des nouveaux procédés de réalisation de motifs ont été développés comme le « double patterning », la lithographie extrême UV, la lithographie par électrons ou la graphoépitaxie qui utilise les copolymères à bloc.

Les copolymères à bloc sont des polymères dans lesquels on a deux unités de répétition : un monomère A et un monomère B, le monomère A formant une chaîne, le monomère B formant une chaîne, ces deux chaînes étant liées entre elles par une liaison covalente. Lorsque l'on donne suffisamment de mobilité aux chaines, par exemple en chauffant ces copolymères à bloc, la chaîne A et la chaîne B ont tendance à se séparer en phases et à se réorganiser sous conformations spécifiques, et qui dépendent notamment du ratio entre le monomère A et le monomère B. En fonction de ce ratio, on peut par exemple avoir des sphères de A dans une matrice de B, ou bien des cylindres de A dans une matrice de B, ou encore des lamelles de A et des lamelles de B intercalées. Les copolymères à bloc ont donc la propriété de former des motifs qui peuvent être contrôlés grâce au ratio de monomères A et B.

En outre, la périodicité des motifs formés par les copolymères à bloc est directement reliée à la masse molaire des copolymères à bloc, de sorte qu'en contrôlant cette masse molaire, on peut contrôler la résolution des motifs qu'ils forment.

Récemment, ces propriétés des copolymères à bloc ont donc été utilisées dans le cadre de procédés de graphoépitaxie de façon à réaliser des motifs de très haute résolution, par exemple de l'ordre de la dizaine de nanomètres.

Les procédés de graphoépitaxie de l'art antérieur consistent généralement à réaliser des motifs primaires à la surface d'un substrat, ces motifs primaires définissant des zones à l'intérieur desquelles les copolymères à bloc vont être déposés pour former des motifs secondaires de meilleure résolution à l'intérieur de ces zones.

Les copolymères à bloc sont généralement déposés par dépôt à la tournette (ou « spin coating » selon l'appellation anglo-saxonne) ; par conséquent, les motifs primaires doivent résister au solvant auquel sont mélangés les copolymères à bloc.

En outre, suite au dépôt des copolymères à bloc, ces derniers sont recuits de façon à ce qu'ils se réorganisent et forment les motifs voulus. Par conséquent, les motifs primaires doivent également présenter une excellente tenue en température.

Un tel procédé est par exemple décrit dans le document « « Ultralarge-area block copolymer lithography via soft graphoepitaxy » (JEONG et al.).

Afin d'assurer aux motifs primaires une bonne tenue en température et au solvant, le document « Graphoepitaxial assembly of symmetric block copolymers on weakly preferential substrates » (Han et al. - Advanced Materials - 2010, 22, 4325-4329) propose de réaliser des motifs en résine par lithographie optique, puis de transférer ces motifs en résine dans un substrat rigide, par exemple en silicium. Ainsi, les motifs réalisés dans le substrat rigide résistent à la fois au solvant et à la température. Toutefois, l'étape de transfert des motifs en résine dans le substrat rigide complexifie le procédé de graphoépitaxie.

Une autre solution pour avoir des motifs primaires qui résistent à la fois au solvant et à la température est présentée dans la publication de Cheng et al, ACS Nano, Vol. 4, NO. 8, 4815-4823, IBM Almaden Research Center, qui propose de réaliser des motifs en résine par lithographie optique, puis de traiter ces motifs en résine de façon à les durcir en déposant une couche protective (également appelée « top coat ») sur les motifs en résine. Toutefois, cette étape de dépôt d'une couche protective complexifie également le procédé de graphoépitaxie et augmente son coût.
Dans tous les procédés mentionnés ci-dessus, les domaines de copolymère à bloc obtenus sont orientés parallèlement au motif de résine (i.e. dans le sens de la grande longueur du motif de résine).

Le document "Ultralarge-area block copolymer lithography via soft graphoepitaxy" (Seong-Jun Jeong et al. - Journal of Materials Chemistry - 2011, vol. 21, no. 16, 5856-5859) décrit un procédé de réalisation de motifs à la surface d'un substrat par graphoépitaxie comportant les étapes de dépôt d'une couche de résine à la surface du substrat, une étape de réalisation de motifs en résine à la surface du substrat, et une étape de dépôt d'une couche d'un copolymère à bloc dans les espaces définis par les motifs en résine. Ce document mentionne également que la résine devra être choisie pour résister au traitement thermique nécessaire à la réorganisation des chaînes du copolymère à bloc.

Le document US 2010/093172 A1 décrit un procédé dans lequel une étape de durcissement de motifs en résine est réalisée en utilisant un traitement plasma HBr, et ce afin de rendre insoluble les motifs en résine vis-à vis de solvant organique.

### EXPOSE DE L'INVENTION

L'invention vise à remédier aux inconvénients de l'état de la technique en proposant un procédé de graphoépitaxie simplifié permettant notamment d'obtenir des géométries différentes de domaines par rapport aux domaines orientés parallèlement au motif de résine, par exemple des domaines perpendiculaires aux flancs des motifs (i.e. dans le sens de la petite longueur du motif de résine) ou perpendiculaires au substrat.
Pour ce faire, est proposé selon un premier aspect de l'invention, un procédé de réalisation de motifs à la surface d'un substrat par graphoépitaxie comportant les étapes suivantes :
- une étape de dépôt d'une couche de résine à la surface du substrat;
- une étape de réalisation de motifs en résine à la surface d'un substrat ;
- une étape de durcissement des motifs en résine par création d'une couche de carbone amorphe à la surface des motifs en résine ;
- une étape de dépôt d'une couche de copolymère statistique après l'étape de durcissement des motifs en résine ;
- une étape de greffage de la couche de copolymère statistique sur les motifs en résine, entre les motifs en résine et sur les flancs des motifs en résine, par recuit ;
- une étape de dépôt d'une couche d'un copolymère à bloc dans les espaces définis par les motifs en résine après l'étape de durcissement des motifs et le greffage de la couche de copolymère statistique.

Le copolymère statistique permet de neutraliser la surface sur laquelle sera déposé le copolymère à bloc, c'est-à-dire que les énergies d'interaction de chaque bloc du copolymère à bloc avec le substrat seront les mêmes. La neutralisation de surface favorise notamment la disposition des domaines du copolymère à bloc perpendiculairement à la surface sur laquelle celui-ci sera déposé. Le copolymère statistique est de préférence composé des mêmes monomères que ceux qui composent le copolymère à bloc.

L'étape de dépôt de la couche de copolymère statistique a lieu après l'étape de durcissement du motif en résine. En effet, le fait de créer une couche de carbone amorphe sur le motif en résine permet de greffer plus facilement la couche de copolymère statistique sur le motif en résine, ce qui n'était pas le cas avec les procédés de l'art antérieur. On peut ainsi réaliser de nouvelles géométries de motifs avec le copolymère à bloc, par exemple en favorisant la disposition des domaines perpendiculaires aux flancs des motifs en résine motifs (i.e. dans le sens de la petite longueur du motif de résine) quand on utilise un copolymère à bloc lamellaire, ce qui n'était pas le cas avec les procédés de l'art antérieur. On peut également obtenir des cylindres organisés et perpendiculaires au substrat en utilisant des copolymères à bloc cylindrique.

Le procédé selon l'invention permet par ailleurs de durcir le motif en résine grâce à une étape de création de carbone amorphe (encore appelé graphite, ces deux expressions étant indifféremment employés dans la suite du document) à la surface du motif en résine. Le motif en résine devient dès lors résistant à des températures allant jusqu'à 350°C. En outre, le fait de créer du carbone amorphe à la surface du motif en résine le rend résistant au solvant. Le motif en résine n'a donc plus besoin d'être transféré dans un masque dur. Le copolymère amorphe peut alors être déposé par dépôt à la tournette sans que le solvant utilisé ne détériore le motif en résine. En outre, le motif en résine n'est plus détérioré par les recuits. Cette couche de graphite à une épaisseur de quelques nanomètres, typiquement comprise entre 1 et 5 nm, par exemple de 3 nm.

Le procédé selon l'invention peut également comporter une ou plusieurs des caractéristiques ci-après prises individuellement ou selon toutes les combinaisons techniquement possibles.

Selon différents modes de réalisation, l'étape de durcissement du motif en résine peut être :
- une étape de traitement du motif en résine par un plasma; ce plasma peut être un plasma argon Ar, Hélium He, dihydrogène H₂. Ce plasma est de préférence un plasma acide bromhydrique HBr. En effet, la création de la couche de carbone amorphe avec un plasma HBr est très rapide, et la couche de carbone amorphe ainsi créée est suffisamment épaisse pour que le motif en résine soit résistant aux solvants et aux recuits.
- une étape de bombardement du motif en résine avec des ions tels que des ions argon ou hélium.

Selon un mode de réalisation, le motif en résine est réalisé par lithographie optique de la couche de résine.

Avantageusement, le procédé comporte en outre une étape de dépôt d'une couche anti-réflective préalablement à l'étape de réalisation du motif en résine. Cette couche anti-réflective permet d'éviter les interférences destructives lors de la lithographie optique. Lorsque le motif en résine est soumis à un plasma HBr ou à un bombardement d'ions hélium ou argon, la couche antiréflective est également soumise à ce plasma HBr ou à ce bombardement d'ions hélium ou argon, de sorte que sa surface est également graphétisée. Ainsi, il est alors possible de greffer le copolymère statistique également à la surface de la couche antiréflective.

Avantageusement, le procédé comporte, suite à l'étape de dépôt de la couche de copolymère à bloc, une étape de réorganisation de la couche de copolymère à bloc par recuit. Cette étape permet de créer des motifs de très bonne résolution à partir du copolymère à bloc.

Avantageusement, le procédé comporte en outre, suite à l'étape de réorganisation de la couche de copolymère à bloc, une étape d'élimination d'une des phases de la couche de copolymère à bloc réorganisée par exemple par traitement plasma oxygène ou encore par traitement avec de l'acide acétique.

### BREVES DESCRIPTION DES FIGURES

D'autres caractéristiques et avantages de l'invention ressortiront à la lecture de la description détaillée qui suit, en référence aux figures annexées, qui illustrent :

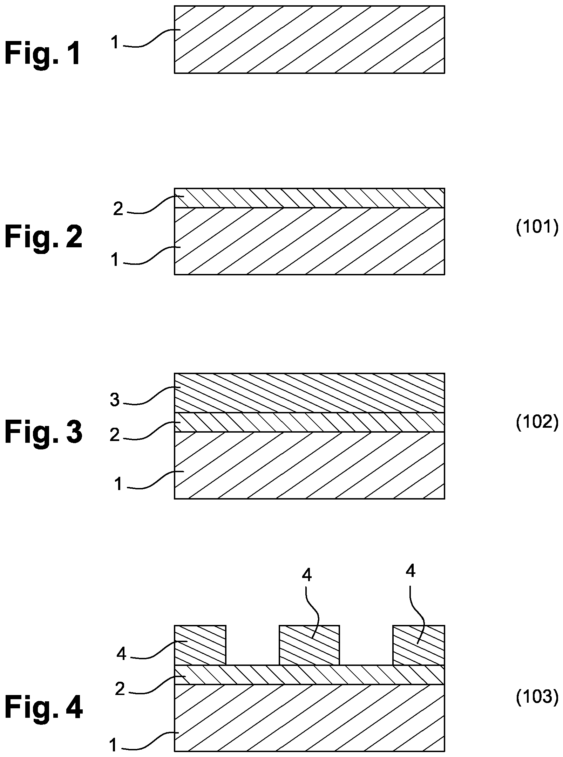

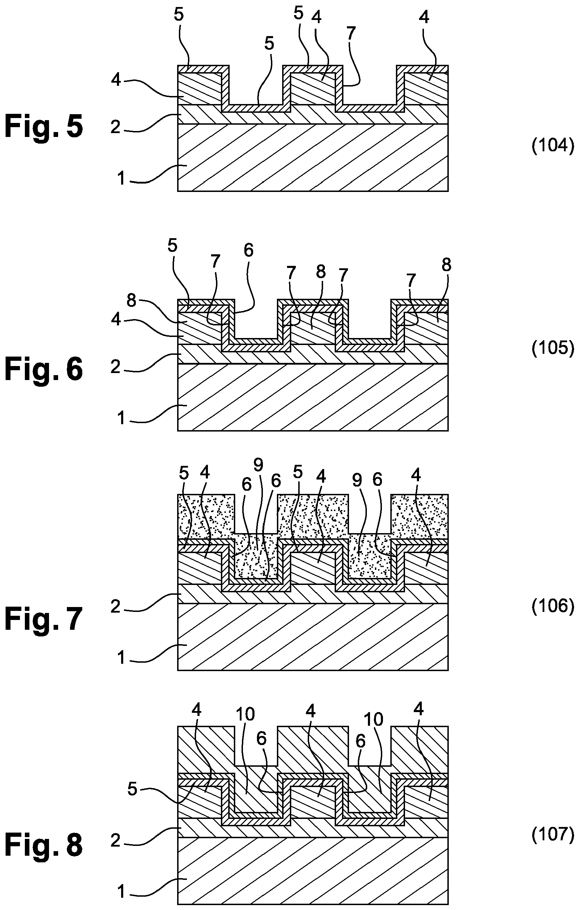

- Les figures 1 à 10, un procédé selon un premier mode de réalisation de l'invention.

Pour plus de clarté, les éléments identiques ou similaires sont repérés par des signes de références identiques sur l'ensemble des figures.

### DESCRIPTION DETAILLEE D'AU MOINS UN MODE DE REALISATION

Un procédé de réalisation d'un motif à la surface d'un substrat 1 par graphoépitaxie selon un mode de réalisation de l'invention va maintenant être décrit en référence aux figures.

Le procédé comporte tout d'abord une étape 101 de dépôt d'une couche antiréflective 2 à la surface du substrat 1. Cette couche antiréflective 2 est de préférence déposée par dépôt à la tournette. Cette couche antiréflective 2 est par exemple une couche BARC («Bottom Anti-Reflective Coating »), une couche DARC (« Dielectric Anti-Reflective Coating »), une couche SiARC (« Silicon layer containing an Anti-Reflective Coating »), ou un empilement de ces dernières couches. Apres le dépôt, la couche est recuite afin de la réticuler.

Le procédé comporte une étape 102 de dépôt d'une couche de résine 3 à la surface de la couche antiréflective 2. Cette couche de résine 3 est également déposée par dépôt à la tournette.

Le procédé comporte ensuite une étape 103 de lithographie de la couche de résine 3 de façon à réaliser des motifs de résine 4.

Le procédé comporte ensuite une étape 104 de durcissement des motifs en résine 4 par création d'une couche de carbone amorphe 5 à la surface des motifs en résine 4.

Selon un premier mode de réalisation, cette étape 104 de durcissement des motifs en résine 4 par création d'une couche de carbone amorphe 5 à la surface des motifs en résine peut être réalisée en plaçant les motifs en résine 4 dans un appareil de gravure par plasma. Ce plasma est de préférence un plasma HBr (acide bromhydrique). Cette étape de gravure des motifs en résine par plasma HBr est de préférence réalisée sous une pression comprise entre 1-100mT et une température comprise entre 40°C et 100°C. Le débit de gaz HBr bombardé sur les motifs en résine est de préférence compris entre 50 et 500 sccm (1sccm=1cm³/min). L'appareil de gravure utilisé présente de préférence une puissance comprise entre 100 et 1500 W. Le plasma est réalisé pendant une durée typiquement comprise entre 30 et 100 secondes, par exemple 60 secondes. L'homme du métier saura adapter ces conditions pour obtenir une couche de graphite d'épaisseur suffisante typiquement comprise entre 1 et 5 nanomètres.

Selon un deuxième mode de réalisation, cette étape 104 de durcissement des motifs en résine 4 par création d'une couche de carbone amorphe 5 à la surface des motifs en résine peut être réalisée en bombardant des ions hélium ou argon sur les motifs en résine 4. Dans ce cas, les motifs en résine 4 sont soumis à des traitements d'implantation ionique utilisant des espèces ioniques tels que l'He ou l'Ar, avec une énergie entre 1 et 5 eV, et pour des vides de l'ordre de 5 e-7 a 5 e-6 torr. La dose implantée sera adaptée par l'homme du métier, à l'aide des logiciels de simulation disponibles (par exemple le logiciel SRIM), pour obtenir un profil d'implantation permettant l'obtention en surface d'une couche de graphite de l'épaisseur requise.

Dans les deux cas, cette étape de durcissement des motifs en résine par création d'une couche de carbone amorphe 5 à la surface des motifs en résine 4 permet aux motifs en résine 4 de résister à la fois aux solvants utilisés pour le dépôt à la tournette et aux recuits allant jusqu'à 350°C. En outre, lors de cette étape, du carbone amorphe est créé à la surface des motifs en résine, mais également à la surface de la couche antiréflective 2, et plus généralement à la surface de toute couche en matière organique, ce qui permet de solidifier ces couches, mais également de favoriser le greffage ultérieur d'une couche de copolymère statistique, comme on va le voir dans la suite.

Le procédé comporte ensuite une étape de greffage 105 d'une couche de copolymère statistique 6.

Dans le cas présent, cette couche de copolymère statistique 6 est une couche de PS-r-PMMA qui comprend 70% en volume de PS, ou polystyrène, et 30% de PMMA, polyméthacrylate de méthyle.

Cette couche de copolymère statistique 6 est d'abord étalée par dépôt à la tournette en diluant le copolymère statistique dans un solvant adapté, du toluène par exemple. Plus précisément, on mélange de préférence 1.5% en masse de PS-r-PMMA dans du toluène.

La couche de copolymère statistique 6 est ensuite greffée thermiquement par recuit, dans le cas présent à 180°C pendant 48 heures sous atmosphère inerte.

L'échantillon est ensuite rincé dans du toluène.

Une monocouche de copolymère statistique 6 est ainsi greffée sur la résine durcie, sans que l'étape de greffage de cette monocouche n'ait endommagé les motifs en résine.

En outre, le greffage de la couche de copolymère statistique est favorisé par la présence de la couche de carbone amorphe.

Ainsi, dans le cas présent, la monocouche de copolymère statistique 6 est greffée non seulement sur les flancs 7 des motifs en résine 4, mais également sur la couche antiréflective 2, entre deux motifs en résine 4 successifs et sur les motifs en résine 4.

Cette couche de copolymère statistique 6 permet de neutraliser les surfaces sur lesquelles elle est déposée de façon à favoriser la disposition perpendiculaire des domaines qui seront créés par la suite.

Le procédé comporte ensuite une étape 106 de dépôt d'un copolymère à bloc 9 dans les espaces définis par les motifs en résine 4 ainsi que sur les motifs en résine 4. Le copolymère à bloc 9 est de préférence composé des mêmes monomères que le copolymère statistique qui a été déposé précédemment.

Dans le cas présent, le copolymère à bloc 9 utilisé est un copolymère à bloc PS-b-PMMA lamellaire contenant respectivement 50% en volume de polystyrène PS et 50% en volume de polyméthacrylate de méthyle ou PMMA.

Ce copolymère à bloc 9 est étalé par dépôt à la tournette, en utilisant par exemple une solution 1.5% massique de copolymère à bloc dilué dans du toluène. Le copolymère à bloc est chauffé à 240°C pendant 10 minutes. Le copolymère à bloc se réorganise alors, notamment en fonction du ratio entre le monomère polystyrène et le monomère polyméthacrylate de méthyle. Ainsi, on obtient des lamelles de polystyrène et des lamelles de polyméthacrylate de méthyle. On notera que le copolymère à bloc se réorganise aussi bien dans les espaces entre les motifs de résine 4 que sur les motifs de résine 4.

Le procédé comporte ensuite une étape 107 d'élimination d'une des phases de la couche de copolymère à bloc réorganisé 10, ici de la phase de polyméthacrylate de méthyle. Pour cela, on plonge la couche de copolymère à bloc réorganisé 10 dans de l'acide acétique concentré à 99% pendant 10 minutes.

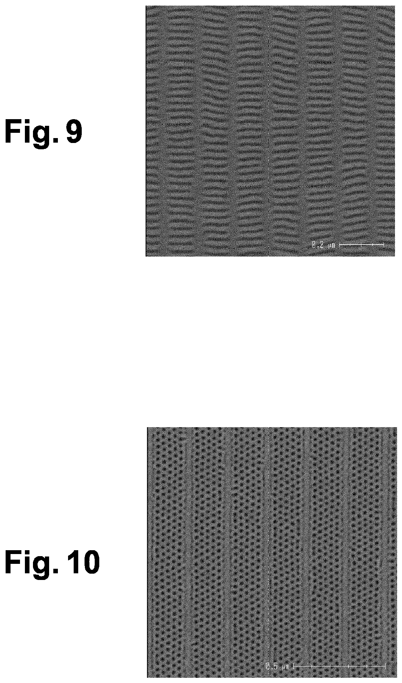

On obtient ainsi des motifs en polystyrène, représentés sur la figure 9, de très haute résolution puisque la résolution des motifs obtenus est du même ordre de grandeur que la longueur des chaînes de monomères du copolymère à bloc utilisé. Les motifs ainsi obtenus sont ensuite utilisés pour graver le substrat au travers des ouvertures laissées entre les motifs ; au niveau des ouvertures situées au-dessus des motifs de résine, ces ouvertures débouchent dans la résine et le substrat n'est donc pas gravé à ce niveau (i.e. au-dessus des motifs de résine). On élimine ensuite le copolymère à bloc réorganisé et la résine pour ne conserver que le substrat gravé au niveau des espaces entre les plots de résine.

En outre, l'orientation de ces motifs dépend de la couche de copolymère statistique et de l'endroit où cette couche a été déposée. Ainsi, sur la figure 9, on a obtenu des motifs qui s'étendent transversalement entre deux motifs de résine, car la couche de copolymère statistique avait été déposée également sur les flancs des motifs en résine.

Au lieu d'obtenir des lamelles grâce au copolymère à bloc, comme représenté sur la figure 9, on pourrait obtenir d'autres motifs. Ainsi, si lors de l'étape 106 de dépôt d'un copolymère à bloc, on utilise un copolymère à bloc PS-b-PMMA cylindrique contenant respectivement 70% en volume de polystyrène PS et 30% en volume de polyméthacrylate de méthyle ou PMMA, au lieu de copolymère lamellaire, on obtiendra suite à l'étape 107 des cylindres perpendiculaires au substrat, comme représenté sur la figure 10. Dans ce cas, on obtient un arrangement régulier de cylindres sur toute la surface du substrat. Une fois effectuée la gravure du substrat au-travers des espaces entre les cylindres, on obtient un arrangement régulier de trous dans le substrat. Il convient ici de noter que l'absence de copolymère statistique sur toute la surface (notamment sur les motifs de résine ou sur les flancs) entraînerait une rupture de l'arrangement régulier au niveau des flancs des motifs de résine de sorte qu'après gravure, on obtiendrait un arrangement régulier dans les zones entre chaque motif de résine mais pas d'une zone à l'autre : la présence de copolymère statistique sur toute la surface rendue possible grâce à la création préalable d'une couche de carbone amorphe est donc avantageuse pour l'obtention d'un arrangement réguliers de motifs transférés par gravure dans le substrat.

Naturellement, l'invention n'est pas limitée aux modes de réalisation décrits en référence aux figures et des variantes pourraient être envisagées sans sortir du cadre de l'invention. Ainsi, l'invention n'est pas limitée aux copolymères à bloc donnés à titre d'exemple, ni aux copolymères statistiques cités.

## Revendications

1. Procédé de réalisation de motifs à la surface d'un substrat par graphoépitaxie comportant les étapes suivantes :
- une étape (102) de dépôt d'une couche de résine (3) à la surface du substrat (1) ;
- une étape (103) de réalisation de motifs en résine (4) à la surface d'un substrat (1) ;
- une étape (104) de durcissement des motifs en résine (4) par création d'une couche de carbone amorphe (5) à la surface des motifs en résine (4) ;
- une étape (106) de dépôt d'une couche de copolymère statistique (6) après l'étape (104) de durcissement des motifs en résine ;
- une étape de greffage de la couche de copolymère statistique (6) sur les motifs en résine, entre les motifs en résine et sur les flancs des motifs en résine, par recuit ;
- une étape (9) de dépôt d'une couche d'un copolymère à bloc (9) dans les espaces définis par les motifs (4) en résine après l'étape de durcissement des motifs (4) et le greffage de la couche de copolymère statistique (6).

2. Procédé selon la revendication précédente, dans lequel l'étape (104) de durcissement des motifs en résine (4) est une étape de traitement des motifs en résine (4) par un plasma gazeux tel qu'un plasma HBr.

3. Procédé selon la revendication 1, dans lequel l'étape (104) de durcissement des motifs en résine est une étape de bombardement des motifs en résine (4) avec des ions tels que des ions Hélium ou Argon.

4. Procédé selon l'une des revendications précédentes, dans lequel les motifs en résine (4) sont réalisés par lithographie optique de la couche de résine (3).

5. Procédé selon l'une des revendications précédentes, comportant en outre une étape de dépôt d'une couche antiréflective (2) à la surface du substrat (1).

6. Procédé selon l'une des revendications précédentes comportant en outre, suite à l'étape de dépôt de la couche de copolymère à bloc (9), une étape (107) de réorganisation de la couche de copolymère à bloc (9) par recuit.

7. Procédé selon la revendication précédente, comportant en outre, suite à l'étape (107) de réorganisation de la couche de copolymère à bloc, une étape d'élimination d'une des phases de la couche de copolymère à bloc réorganisée (10).

8. Procédé selon l'une des revendications précédentes **caractérisé en ce que** le copolymère statistique est composé des mêmes monomères que ceux qui composent le copolymère à bloc.

9. Procédé selon l'une des revendications précédentes **caractérisé en ce que** le copolymère à bloc est un copolymère à bloc lamellaire.

10. Procédé selon l'une des revendications 1 à 8 **caractérisé en ce que** le copolymère à bloc est un copolymère à bloc cylindrique.

## Patentansprüche

1. Realisierungsverfahren von Mustern an der Oberfläche eines Substrats per Grapho-Epitaxie, umfassend die folgenden Schritte:
- einen Schritt (102) zum Aufbringen einer Harzschicht (3) an der Oberfläche des Substrats (1);
- einen Realisierungsschritt (103) von Mustern aus Harz (4) an der Oberfläche eines Substrats (1);
- einen Aushärtungsschritt (104) der Muster aus Harz (4) per Kreation einer amorphen Karbonschicht (5) an der Oberfläche der Muster aus Harz (4);
- einen Schritt (106) zum Aufbringen einer statischen Copolymerschicht (6) nach dem Aushärtungsschritt (104) der Muster aus Harz;
- einen Aufpfropfschritt der statischen Copolymerschicht (6) auf den Mustern aus Harz zwischen den Mustern aus Harz und auf den Flanken der Muster aus Harz per Nachglühen;
- einen Schritt (102) zum Aufbringen einer Blockpolymerschicht (9) in den durch die Muster (4) aus Harz definierten Räumen nach dem Aushärtungsschritt der Muster (4) und dem Aufpfropfen der statischen Copolymerschicht (6).

2. Verfahren gemäß dem voranstehenden Anspruch, bei dem der Aushärtungsschritt (104) der Muster aus Harz (4) ein Bearbeitungsschritt der Muster aus Harz (4) durch ein gashaltiges Plasma, wie z. B. einem HBr ist.

3. Verfahren gemäß Anspruch 1, bei dem der Aushärtungsschritt (104) der Muster aus Harz ein Beschussschritt der Muster aus Harz (4) mit Ionen, wie z. B. Helium- oder Argonionen, ist.

4. Verfahren gemäß einem der voranstehenden Ansprüche, bei dem die Muster aus Harz (4) per optischer Lithographie der Schicht aus Harz (3) realisiert sind.

5. Verfahren gemäß einem der voranstehenden Ansprüche, umfassend darüber hinaus einen Schritt zum Aufbringen einer antireflektierenden Schicht (2) auf der Oberfläche des Substrats (1).

6. Verfahren gemäß einem der voranstehenden Ansprüche, umfassend darüber hinaus im Anschluss an den Schritt zum Aufbringen der Blockpolymerschicht (9) einen Reorganisationsschritt (107) der Blockpolymerschicht (9) per Nachglühen.

7. Verfahren gemäß dem voranstehenden Anspruch, umfassend darüber hinaus im Anschluss an den Reorganisationsschritt (107) der Blockpolymerschicht einen Beseitigungsschritt einer der Phasen der reorganisierten Blockpolymerschicht (10).

8. Verfahren gemäß einem der voranstehenden Ansprüche, **dadurch gekennzeichnet, dass** das statische Copolymer aus denselben Monomeren zusammengesetzt ist wie die, die das Blockpolymer bilden.

9. Verfahren gemäß einem der voranstehenden Ansprüche, **dadurch gekennzeichnet, dass** das Blockpolymer ein lamellenartiges Blockpolymer ist.

10. Verfahren gemäß einem der Ansprüche 1 bis 8, **dadurch gekennzeichnet, dass** das Blockpolymer ein zylindrisches Blockpolymer ist.

## Claims

1. A method for making patterns at the surface of a substrate by graphoepitaxy including the following steps:
- a step (102) of depositing a layer of resin (3) at the surface of the substrate (1);
- a step (103) of making resin patterns (4) at the surface of a substrate (1);
- a step (104) of hardening the resin patterns (4) by creating a layer of amorphous carbon (5) at the surface of the resin patterns (4);
- a step (106) of depositing a layer of random copolymer (6) after the step (104) of hardening the resin patterns (4);
- a step of grafting the layer of random copolymer (6) on the resin patterns, between the resin patterns and on the flanks of the resin patterns, by annealing;
- a step (9) of depositing a layer of a block copolymer (9) in the spaces defined by the resin patterns (4) after the step of hardening the patterns (4) and grafting the layer of random copolymer (6).

2. The method according to the preceding claim, wherein the step (104) of hardening the resin patterns (4) is a step of processing the resin patterns (4) by a gas plasma such as an HBr plasma.

3. The method according to claim 1, wherein the step (104) of hardening the resin patterns is a step of bombarding the resin patterns (4) with ions such as Helium or Argon ions.

4. The method according to one of the preceding claims, wherein the resin patterns (4) are made by optical lithography of the resin layer (3).

5. The method according to one of the preceding claims, further including a step of depositing an antireflecting layer (2) at the surface of the substrate (1).

6. The method according to one of the preceding claims, further including, after the step of depositing the layer of block copolymer (9), a step (107) of reorganising the layer of block copolymer (9) by annealing.

7. The method according to the preceding claim, further including, after the step (107) of reorganizing the layer of block copolymer, a step of removing one of the phases of the reorganised layer of block copolymer (10).

8. The method according to one of the preceding claims, **characterised in that** the random copolymer comprises the same monomers as those which comprise the block copolymer.

9. The method according to one of the preceding claims, **characterised in that** the block copolymer is a lamellar block copolymer.

10. The method according to one of claims 1 to 8, **characterised in that** the block copolymer is a cylindrical block copolymer.
